# EUROPEAN PATENT APPLICATION

(11) **EP 0 890 843 A2**
(43) Date of publication of application: **13.01.1999**
(21) Application number: 98401463.9
(22) Date of filing: 15.06.1998
(51) Int. Cl.: G01R 1/04

(54) **Test socket assembly**

(30) Priority: 07.07.1997 US 888608
(71) Applicant: SCHLUMBERGER TECHNOLOGIES, INC., San Jose, California 95110-1397 (US)
(72) Inventor: Knostman, Steven William, Columbus, Ohio 43214 (US)
(74) Representative: Lemoyne, Didier

(57) **Abstract**

A socket assembly includes a socket base having a recess for receiving the device under test; a lid; latches for releasably closing the lid over the socket base; a backup member positioned within the lid so as to be moveable relative thereto; a lock down member located in the lid and contacting the backup member such that when the lid is connected to the socket base, the lock down member is operable to urge the backup against the device under test; a heat exchange device located in the backup member so as to contact an integrated circuit in the device under test when the backup is urged against the device under test; and control lines passing from the heat exchange device through the lock down member, the control lines being connectable to a heat exchange control system located externally to the apparatus.

## Description

### FIELD OF THE INVENTION

The present invention relates to the field of sockets and assemblies for use in the testing of integrated circuit devices (IC's). In particular, the invention relates to sockets and assemblies which can be used to provide an interface between a tester and a DUT.

### BACKGROUND OF THE INVENTION

It is generally desirable to test IC devices before they are finally packaged ready for final use. The part-finished devices typically comprise an IC chip mounted on a substrate with contact pads or pins connected to the chip. In testing, it is necessary for the tester to be able to contact these pads to execute a test, either on its own or as part of a burn-in operation. Various types of socket assemblies or carriers have been used in the past for providing an interface between a DUT and a tester, either in burn-in or conventional testing.

US 5,517,125 describes a reusable carrier for use in burn-in testing of an unpackaged die. This carrier comprises a base having a hinged lid with a spring-loaded catch to hold the lid closed. A spring in the lid engages the DUT to hold conductive pads on the DUT against traces in the base which can be used to connect a tester. A vacuum port is also described for holding the DUT to a substrate during testing when appropriate.

USS 4,970,460 describes a controlled impedance test site for testing IC's, having an extender body, a spring-loaded DUT ejector, a cover and contacts to the DUT. Air channels in the extender body are connected to an air conditioning unit to provide temperature controlled air to the DUT during testing.

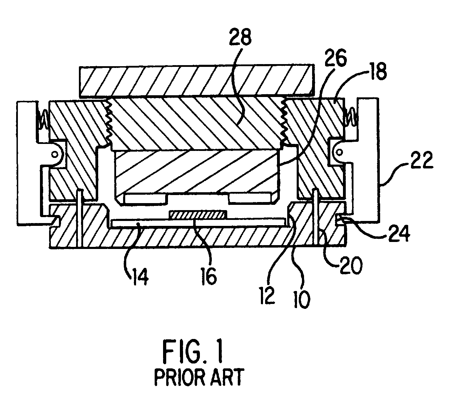

A further form of known socket for testing IC's is shown in Figure 1. A socket base 10 is provided with a recess 12 in its upper surface which accommodates a DUT 14 including an IC 16. Contact pads (not shown) contact pogo pins in the base (also not shown) for connection to a tester. A lid 18 is located on the base 10 by means of locating pins 20 and held in place by means of a pair of spring-loaded latches 22 which engage in grooves 24 in the base 10. A backup 26 which is configured to engage load bearing portions of the DUT 14 is located in the lid 18 on a lock down 28. On rotation of the lock down 28, the backup 26 is urged against the DUT 14 so as to press the contact pads onto the pogo pins. Pressure is released by rotating the lock down in the opposite direction and the latches released to allow removal of the DUT from the socket after testing.

Various approaches have been proposed for controlling the temperature of a DUT during testing. These include soaking the DUT in a flow or bath of temperature-controlled fluid, or applying a heat exchanger, heat sink or heater to the DUT during testing in an attempt to maintain the DUT at a predetermined temperature during a test. US 5,164,661 describes a burn-in tower in which a DUT is inserted into a socket secured to a mother board. A conductive module including a heating assembly is brought into contact with the DUT and heat is applied during a test.

It is an object of the present invention to provide a socket which allows a heat exchange device to be placed in contact with the DUT.

### SUMMARY OF THE INVENTION

According to a first aspect of the present invention, there is provided apparatus for connection to a socket for a DUT, the apparatus comprising: (a) a lid; (b) means for releasably closing the lid over the socket; (c ) a backup member positioned within the lid so as to be moveable relative thereto; (d) a lock down member located in the lid and contacting the backup member such that when the lid is closed over the socket, the lock down member is operable to urge the backup against the DUT; (e) a heat exchange device located in the backup member so as to contact the IC when the backup is urged against the DUT; and (f) control lines passing from the heat exchange device through the lock down member for connection to a heat exchange control system located externally to the apparatus.

A second aspect of the invention provides a socket assembly which comprises a socket base having a recess defined therein for receiving the DUT in addition to the apparatus according to the first aspect of the invention.

The lid is typically closed over the socket base by means of spring-loaded latches which engage grooves or recesses formed in the base. In one preferred embodiment, the lid is secured to the base by a pair of latches. In other embodiments, the lid can be hinged to the base or separate and connected by another releasable connecting means.

The backup member preferably includes a plate which is shaped to contact load bearing, or less load sensitive parts of the DUT and has an aperture through which the heat exchanger can contact the IC. The purpose of the backup is to allow sufficient pressure to be applied to the DUT to ensure good electrical contact with the base while avoiding damaging the DUT in general and the IC in particular.

The lock down member can be formed from a threaded ring which projects through an aperture in the lid and operates to urge the backup against the DUT. Extensions can be provided to allow manual adjustment of the ring. Alternatively, the lock down could be in the form of a cam operated member which engages the backup. A ring is the preferred form of lock down but other structures can be used if required.

The heat exchanger is preferably formed from an electric heater which contacts the IC and a fluid cooled heat sink which contacts the heater. The control of the heat exchanger can be as described in (65.249) or can be,in response to a measured temperature of the DUT, in which case, the heat exchange will often include a temperature sensor.

### BRIEF DESCRIPTION OF THE DRAWINGS

Figure 1 shows a prior art socket assembly;
Figure 2 shows an exploded view of a socket assembly according to one embodiment of the invention;
Figure 3 shows a cross section of the socket assembly shown in Figure 2;
Figure 4 shows a perspective view of the complete assembly shown in Figure 2;
Figure 5 shows a view of a test system in which the socket shown in Figures 2 - 4 might be used.

### DECRIPTION OF THE PREFERRED EMBODIMENT

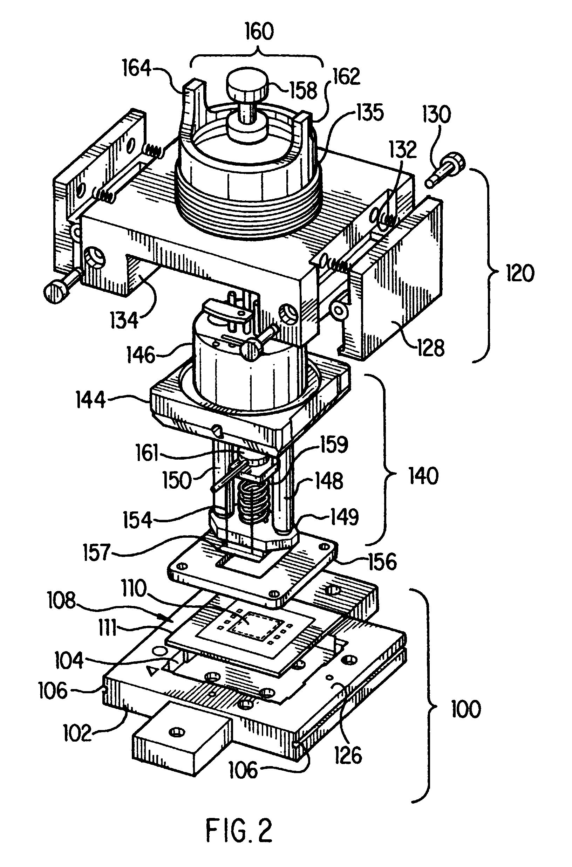

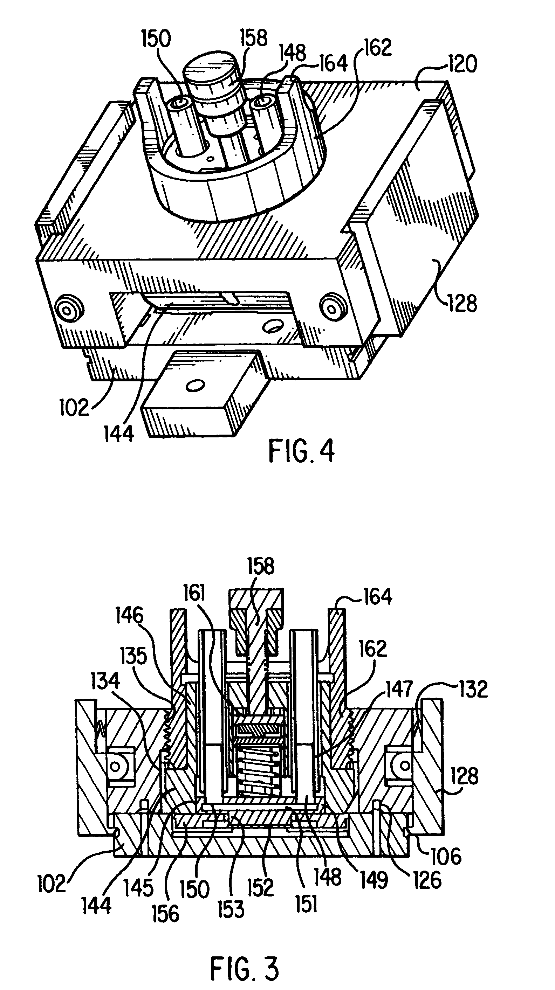

Figures 2 - 4, show an embodiment of the invention which includes the following functional sections: base 100, lid 120, backup 140 and lock down 160, as indicated generally in Figure 2.

The base 100 comprises a socket base 102 having a recess 104 formed in an upper surface, and grooves 106 extending along opposite sides of the base 102. The recess 104 is sized to receive a DUT 108 having an IC 110 mounted on a substrate 111. The DUT 108 has contact pads (not shown) which match with pogo pins (not shown) in the base 102 to allow contact with a tester.

The lid 120 is formed from any suitable material such as aluminum, engineering plastic, etc., and has a lower face which engages the upper surface of the base 102 when the lid 120 covers the base 102. The lid 120 is located over the base 102 by means of pins 126 and held in place by a pair of latches 128 which are mounted on the sides of the lid 120 on hinge pins 130 and biased by springs 132. The latches 128 engage the grooves 106 in the base 102. A central recess 134 is formed in the lid 120 and a threaded aperture 135 extends through the upper surface of the lid body into the central recess 134.

The backup 140 is housed within the central recess 134 of the lid 120. The backup 140 has a lower backup section 144 which is shaped to fit in the central recess 134 and slide in the recess vertically 104 and has a central opening 145, and a generally cylindrical upper backup section 146 which extends from the lower section 144 and projects through the aperture 136 in the lid 120. The lower and upper backup sections 144, 146 together define a cavity 147. An annular recess 138 is formed in the lower backup section 144 around the upper section 146. A heat exchanger is located within the cavity 147. The heat exchanger includes a fluid cooled heat sink 149 having a fluid inlet 148 and outlet 150 connecting to a chamber 151 in the heat sink and extending upwardly through the cavity 147 and projecting from the upper backup section 146. An electric heater 152 is positioned on an extension 153 of the lower surface of the heat sink 146 and its control leads 154 extend up through the chamber and project from the upper backup section 146. The heat exchanger is retained within the cavity 147 by an end plate 156 which is connected over the opening in the lower backup section 144. The end plate 156 has an aperture 157 which is sized to allow the extension 153 of the heat sink 149 and the electric heater 152 to project below its lower surface. A screw adjuster 158 projects through the upper surface of the upper backup section 146 into the cavity 147. The screw adjuster engages a spring 159 which is located between the inlet 148 and outlet 150 and engages the back of the heat sink 149. A pressure transducer 161 is positioned between the screw adjuster 158 and the spring 161.

The lock down 160 comprises a threaded ring 162 which projects through the threaded aperture 135 in the lid 120 and bears against the surface of the recess 138 on the backup 140. The upper backup section extends through the ring 162. Extensions 164 from the upper part of the ring 162 allow manual rotation of the ring and permit the backup 140 to be urged downward by the lock down ring 162.

In use, the DUT is placed in the recess 104 in the base 102 and the lid 120 is located over the recess 104 on the pins 126 and the latches 128 engaged in the grooves 106 on the base 102. The lock down ring 162 is rotated to force the backup 140 against the DUT 108, the end plate 156 engaging load bearing portions of the DUT 108. The extension 153 of the heat sink 149 carrying the electric heater 152 projects through the aperture 157 in the end plate 156 to engage the IC 110 which projects upwardly on the DUT 108. The contact pressure of the heat exchanger on the IC 110 is adjusted with the screw adjuster 158 and spring 161 so as to ensure effective heat transfer between the IC 110 and the heat exchanger. The pressure transducer 159 is connected to a readout (not shown) to allow the contact pressure to be determined. In order to improve thermal contact between the heat exchanger and the IC 110, a liquid, such as deionized water (other materials such as thermal greases, organic liquids, etc. can be used), can be placed on the upper surface of the IC 110.

In alternative embodiments, the pressure transducer can be omitted as can the adjusting screw if the appropriate contact pressure is known for the DUT and established by set compression of the spring in the backup. In addition, different spring arrangements to that shown in the drawings can be used to ensure the required contact pressure between the heat exchanger and the IC.

To release the DUT, the lock down ring is released and the lid removed by operating the latches so as to disengage from the grooves. This allows the DUT to be removed and replaced by another to be tested.

Figure 5 shows a test situation in which the socket assembly described above can be applied. The socket assembly 200 is connected to a load board 202 which interfaces with the test head 204 of a tester (not shown). The fluid inlet and outlet are connected by supply lines to a coolant recirculator and chiller 206. Control electronics 208 are provided to control operation of the heat exchanger and recirculator and chiller 206 and takes inputs from temperature sensors on the DUT and heat exchanger and provides power to the electric heater. The control electronics 208 and the recirculator and chiller and supply and electrical lines can be located together in a single mobile unit as shown which can be brought up to the test head of any suitable tester. Thus the present invention provides a socket which will allow a DUT to be tested while under thermal control without the need for a modified tester or specialist handling equipment. This allows thermal control to be applied in an engineering environment. Although not shown here, the socket assembly can be shrouded and bathed in dry nitrogen to prevent condensation, particularly of thermal contact material, collecting on the apparatus during test at below ambient dew point.

The present invention provides a socket which allows a heat exchanger to be placed against a DUT so as to enable thermal control during testing. The embodiment described above has the further advantage that the pressure applied by the backup to the DUT is independent of the pressure applied by the heat exchanger to the IC. This allows effective and repeatable contact pressure for the heat exchanger to improve thermal transfer behavior, while avoiding the possibility of damaging the IC. In the case where the adjusting screw is not required, the appropriate contact pressure is ensured by the use of the spring. Thus the simple operation of the lock down is sufficient to form the DUT contacts and apply the heat exchanger.

It will be appreciated that other changes can be made within the scope of the invention, the method of attaching the lid to the base can be chosen to suite requirements. For example, the lid could be hinged to the base along one edge and a latch provided on the other, or a snap fit arrangement could be adopted. The method of actuating the lock down can also be changed, for example a cam or linkage arrangement could be substituted for the screw arrangement described.

## Claims

1. Apparatus for connection to a socket having a device under test which includes an integrated circuit device, the apparatus comprising:
(a) a lid;
(b) means for releasably closing the lid over the socket;
(c) a backup member positioned within the lid so as to be moveable relative thereto;
(d) a lock down member located in the lid and contacting the backup member such that when the lid is closed over the socket, the lock down member is operable to urge the backup member against the device under test;
(e) a heat exchange device located in the backup member so as to contact an integrated circuit in the device under test when the backup member is urged against the device under test; and
(f) control lines passing from the heat exchange device through the lock down member, the control lines being connectable to a heat exchange control system located externally to the apparatus.

2. Apparatus as claimed in claim 1, wherein the heat exchange device is moveable relative to the backup member and is arranged to contact the integrated circuit with a different pressure to that applied to the device under test by the backup member.

3. Apparatus as claimed in claim 2, wherein the heat exchange device is mounted on a spring in the backup member.

4. Apparatus as claimed in claim 3, wherein means are provided for adjusting compression in the spring to control the pressure with which the heat exchange device is applied to the integrated circuit.

5. Apparatus as claimed in claim 4, wherein the means for adjusting spring compression comprises a screw adjuster positioned in the lock down member.

6. Apparatus as claimed in claim 1, wherein the lock down member comprises a threaded ring which is located in a correspondingly threaded aperture defined in the lid, one end of the ring bearing against a cooperating surface on the backup member, and the control lines passing through a central portion of the ring.

7. Apparatus as claimed in claim 6, wherein the ring is provided with extensions to allow manual operation of the ring so as to adjust the contact pressure of the backup member on the device under test.

8. Apparatus as claimed in claim 1, wherein the backup member comprises a plate which is shaped to contact those parts of the device under test less sensitive to pressure, and is provided with an aperture through which the heat exchange device may contact the integrated circuit.

9. Apparatus as claimed in claim 1, wherein the heat exchange device comprises a fluid cooled heat sink and an electric heating element.

10. Apparatus as claimed in claim 9, wherein the control lines comprise inlet and outlet lines for cooling fluid. and electrical lines for controlling the heating element and sensing temperature.

11. Apparatus as claimed in claim 1, wherein the lid comprises a face portion which engages the socket when closed and a central recess for receiving the backup member and heat exchange device.

12. Apparatus as claimed in claim 11, wherein the means for connecting the lid to the socket comprises at least one spring-loaded latch which engages a corresponding recess in the socket.

13. Apparatus as claimed in claim 12, wherein latches are provided on opposite sides of the lid.

14. Apparatus as claimed in claim 1, further comprising a pressure transducer for sensing the pressure with which the heat exchange device contacts the integrated circuit.

15. Apparatus as claimed in claim 14, wherein the contact pressure of the heat exchange device is controlled using a spring mounted in the backup member, the compression of which is controlled using a screw adjuster, the pressure transducer being located between the screw adjuster and the spring.

16. A socket assembly for a device under test including an integrated circuit, the assembly comprising:
(a) a socket base having a recess defined therein for receiving the device under test;
(b) a lid;
(c) means for releasably closing the lid over the socket base;
(d) a backup member positioned within the lid so as to be moveable relative thereto;
(e) a lock down member located in the lid and contacting the backup member such that when the lid is closed over the socket base, the lock down member is operable to urge the backup against the device under test.
(f) a heat exchange device located in the backup member so as to contact an integrated circuit in the device under test when the backup is urged against the device under test; and
(g) control lines passing from the heat exchange device through the lock down member, the control lines being connectable to a heat exchange control system located externally to the apparatus.

17. A socket assembly as claimed in claim 16, wherein the h4at exchange device is moveable relative to the backup member and is arranged to contact the integrated circuit with a different pressure to that applied to the device under test by the backup member.

18. A socket assembly as claimed in claim 17, wherein the heat exchange device is mounted on a spring in the backup member.

19. A socket assembly as claimed in claim 18, wherein means are provided for adjusting compression in the spring to control the pressure with which the heat exchange device is applied to the integrated circuit.

20. A socket assembly as claimed in claim 19, wherein the means for adjusting spring compression comprises a screw adjuster positioned in the lock down member.

21. A socket assembly as claimed in claim 16, wherein the lock down member comprises a threaded ring which is located in a correspondingly threaded aperture defined in the lid, one end of the ring bearing against a cooperating surface on the backup member, and the control lines passing through a central portion of the ring.

22. A socket assembly as claimed in claim 21, wherein the ring is provided with extensions to allow manual operation of the ring so as to adjust the contact pressure of the backup member on the device under test.

23. A socket assembly as claimed in claim 16, wherein the backup member comprises a plate which is shaped to contact those parts of the device under test less sensitive to pressure, and is provided with an aperture through which the heat exchange device may contact the integrated circuit.

24. A socket assembly as claimed in claim 16, wherein the heat exchange device comprises a fluid cooled heat sink and an electric heating element.

25. A socket assembly as claimed in claim 24, wherein the control lines comprise inlet and outlet lines for cooling fluid, and electrical lines for controlling the heating element.

26. A socket assembly as claimed in claim 16, wherein the lid comprises a face portion which engages the socket base when closed and a central recess for receiving the backup member and heat exchange device.

27. A socket assembly as claimed in claim 26, wherein the means for connecting the lid to the socket base comprises at least one spring-loaded latch which engages a corresponding recess in the socket base.

28. A socket assembly as claimed in claim 27, wherein latches are provided on opposite sides of the lid.

29. A socket assembly as claimed in claim 16, further comprising a pressure transducer for sensing the pressure with which the heat exchange device contacts the integrated circuit.

30. A socket assembly as claimed in claim 29, wherein the contact pressure of the heat exchange device is controlled using a spring mounted in the backup member, the compression of which is controlled using a screw adjuster, the pressure transducer being located between the screw adjuster and the spring.
